# EUROPEAN PATENT SPECIFICATION

(11) **EP 2 337 333 B1**
(45) Date of publication and mention of the grant of the patent: **19.03.2014**
(21) Application number: 11161782.5
(22) Date of filing: 09.04.2007
(51) Int. Cl.: H04N 5/225, H04N 3/00, H01L 27/146

(54) **Method for mounting protective covers on image capture devices and devices manufactured thereby**
Verfahren zur Montage von Schutzabdeckungen auf Bildaufnahmevorrichtungen und auf diese weise hergestellte Vorrichtungen
Procédé pour monter des capots de protection sur des dispositifs de capture d'images et dispositifs ainsi fabriqués

(30) Priority: 11.04.2006 US 402196
(43) Date of publication of application: 22.06.2011
(62) Divisional of application: 07755070.5
(73) Proprietor: FLEXTRONICS AP, LLC, Broomfield, CO 80021 (US)
(72) Inventor: Tam, Samuel Waising, Daly City, CA 94015 (US); Shangguan, Dongkai, San Jose, CA 95129 (US)
(74) Representative: Witte, Weller & Partner Patentanwälte mbB

(56) References cited:
- EP-A2- 1 387 397
- WO-A1-2006/035963
- JP-A- 2004 247 486
- JP-A- 2005 051 078
- US-A1- 2004 161 871
- US-A1- 2006 051 887
- US-B1- 6 168 965

## Description

### BACKGROUND OF THE INVENTION

### Field of the Invention

This invention relates generally to electronic devices, and more particularly to digital camera modules. More particularly, this invention relates to a method for manufacturing digital camera modules including image capture devices with protective covers mounted thereon.

### Description of the Background Art

Electronic camera modules are currently included in various consumer electronic products such as mobile telephones and hand-held electronic organizers. These camera modules typically include a CCD or CMOS image sensor and a lens assembly mounted on a printed circuit board (PCB). The camera module is then mounted on a PCB of the host device.

Some known camera modules include a protective glass cover mounted over the sensor array of the image capture device to protect the sensor area from contamination, which will adversely affect images captured by the device and render the camera module unacceptable for its intended use. According to current practice, the protective covers are mounted during the assembly of the camera modules. For example, the protective covers can be mounted after the image capture device is mounted on the PCB, but before the lens assembly is mounted over the imager. Although the protective covers are,somewhat effective to prevent contamination of the sensor array, there are some drawbacks to their use.

One disadvantage associated with current methods of mounting protective covers over image capture devices is that it is time consuming to attach the covers to each image capture device. The covers must be placed over the sensor array, without covering other components (e.g., electrical contact pads) disposed on the top surface of the image capture device. Although the protective covers can be placed with automated equipment, the placing of the covers still adds a step to the manufacturing process.

Another disadvantage of known methods is that the protective glass covers need to be thicker than is often desired. The reason for the thicker glass is that the automated equipment used to place the glass covers is incapable of handling glass less than about 300 microns thick without breaking it. As a result, the thicker glass unnecessarily increases the thickness and/or weight of the device.

Another disadvantage is the cost and/or time required to prepare the glass covers. In particular, the individual protective covers are formed by sawing or dicing a sheet of glass. Several cuts are required to process a single sheet of glass, and the cuts must be clean and precise, in order to yield an acceptable finished product. The machinery used to perform the glass sawing operations is expensive, and the time required is substantial. In addition, the finished glass covers must be cleaned and packaged for use by the placing equipment. Thus, the time and cost of preparing the protective covers is substantial.

Another problem with the methods of the prior art are that the protective covers can only protect the sensor array after they are mounted on the image capture device. Therefore, the device is susceptible to contamination by foreign particles during any assembly steps that occur prior to mounting the cover. For example, contamination can result from handling of the image capture devices prior to mounting on the PCB, the process of soldering the image capture devices to the PCB, cleaving of the PCB, or even from the singulation process of separating the image capture devices from the unitary substrate on which they are formed. To compound the problem of contamination, once the protective cover is applied, any contaminants on the sensor array will be trapped, thereby resulting in a permanently defective image capture device.

US 2004/0161871 shows a prior-art method of manufacturing image capture devices.

What is needed, therefore, is a method for mounting protective covers over image capture devices of camera modules that is cheaper, faster, and more efficient than known methods. What is also needed is a method for mounting protective covers over image capture devices of camera modules that has a higher manufacturing quality and yield than known methods. What is also needed is a method for mounting protective covers over image capture devices of camera modules that enables covers that are thinner than the covers of known methods. What is also needed is a method for mounting protective covers over image capture devices of camera modules that reduces the time and expense associated with preparation of the protective covers. What is also needed is a method for mounting protective covers over image capture devices of camera modules that protects the imager from contamination early in the assembly process.

### SUMMARY

The present invention overcomes the problems associated with the prior art by providing methods for mounting protective covers over image capture devices of camera modules that are cheaper, faster, and more efficient than known methods. Methods of the invention have higher manufacturing quality and yield, and facilitates the use of thinner protective covers. Methods of the present invention also reduce the time and expense of preparing the protective covers for mounting and protect the image capture devices against contamination early in the assembly process. The described methods, and/or variations thereof, each provide some, but not necessarily all, of the foregoing advantages.

The invention provides a method of manufacturing camera modules and a camera module manufacturing working piece as recited in claims 1 and 13, respectively.

The inventive methods provide the stated advantages by fixing a plurality of protective covers to a plurality of components when the protective covers and components are each part of a respective unitary substrate. One method includes the steps of providing a unitary component substrate, providing a unitary transparent substrate, bonding the unitary transparent substrate to the unitary component substrate, separating the unitary transparent substrate to form the protective covers, and separating the unitary component substrate to form discrete component parts. The step of separating the unitary transparent substrate is distinct from the step of dividing the component substrate. For example, the transparent substrate can be divided prior to separating the component parts.

The transparent substrate includes a plurality of channels, each having a depth and width, which at least partially define perimeters of the individual protective covers. The channel width defines a predetermined spacing between adjacent protective covers on the component substrate. In a particular method the channels include a first group of channels, parallel to one another, and a second group of channels, parallel to one another and perpendicular to the first group of channels, so the protective covers are rectangular in shape.

The channels in the transparent substrate are at least as deep as a predetermined thickness of the protective covers. The protective covers are then separated from one another by removing material (e.g., via an etching process, a lapping process, a dicing process, etc.) from the top surface (opposite the component substrate) of the transparent substrate until the channels pass completely through the transparent substrate. Due to the width of the channels, after separation the top surface areas of the individual protective covers are significantly smaller than the top surface areas of the associated component parts.

The transparent substrate is bonded to the component substrate by applying a bonding agent to the bottom surfaces of the partially defined protective covers. According to one method, an optical bonding agent is applied to substantially the entire bottom surfaces of the protective covers by, for example, a spin-on process. In an alternate method, the bonding agent is patterned on the bottom surface of each protective cover so that the bonding agent forms a closed perimeter around the peripheral portion of the bottom surface of the protective cover and leaves the central portion (overlying the sensor array) of the bottom surface free of bonding agent. Thus, in this particular method, the bonding agent need not be an optical quality bonding agent. According to yet another particular method, the bonding agent is laminated on the bottom surfaces of the protective covers. According to yet another particular method, the bonding agent applied to the bottom surfaces of the protective covers is a partially cured thermosetting adhesive. The transparent substrate is then positioned such that the bonding agent contacts the top surface of the component substrate and the curing process of the bonding agent is completed. Regardless of the particular bonding method used, it should be understood that the bonding agent can alternatively be applied first to the component substrate.

Methods of the present invention further include mounting a lens holder on the component substrate. In one particular method, the lens holder is mounted on the component substrate after the step of dividing the transparent substrate, but before the step of separating the component parts.

Camera modules manufactured by methods of the present invention are also disclosed. One particular camera module includes a component substrate having a top surface and a transparent protective cover disposed on the top surface of the component substrate. The transparent protective cover can be as thin as or thinner than 300 microns. In a particular embodiment, the component substrate is an image capture integrated circuit chip. In another particular embodiment, the component substrate is a printed circuit board.

A camera module manufacturing workpiece is also disclosed. In a particular embodiment, the camera module manufacturing workpiece includes a unitary component substrate including a plurality of individual component parts, and a unitary transparent substrate including a bottom surface that at least partially defines a plurality of discrete protective covers. Each of the protective covers are bonded to a respective one of the individual component parts. In a more particular embodiment, the discrete protective covers are at least partially defined by channels formed in the bottom surface of the unitary transparent substrate. In another more particular embodiment, the unitary component substrate is an integrated circuit wafer.

### BRIEF DESCRIPTION OF THE DRAWINGS

The present invention is described with reference to the following drawings, wherein like reference numbers denote substantially similar elements:
FIG. 1 is a cross-sectional view of a unitary transparent substrate with channels that partially define a plurality of individual protective covers;
FIG. 2A is a cross-sectional view of the unitary transparent substrate of FIG. 1 with an optical bonding material applied to the individual protective covers;
FIG. 2B is a cross-sectional view of the unitary transparent substrate of FIG. 1 with a patterned bonding material applied to the individual covers;
FIG. 3A is a cross-sectional view of the unitary transparent substrate of FIG. 2A positioned over a unitary component substrate;
FIG. 3B is a cross-sectional view of the components of FIG. 3A fixed to one another by the bonding material to form an intermediate workpiece;
FIG. 4 is a cross-sectional view of the workpiece of Fig. 3B after the bottom surface of the unitary transparent substrate has been removed;
FIG. 5 is a cross-sectional view of the unitary component substrate of Fig. 4 being separated into individual image capture devices with protective covers;
FIG. 6 is a top plan view of an alternate unitary transparent substrate and an alternate unitary component substrate;
FIG. 7 a cross-sectional view of the alternate unitary transparent substrate of Fig. 6;
FIG. 8 is a cross-sectional view of the unitary transparent substrate of FIG. 7 with bonding material applied;
FIG. 9 is a top view of the unitary transparent substrate of FIG. 8;
FIG. 10A shows material being removed from the top surface of an assembled camera module manufacturing workpiece (bottom surface of the unitary transparent substrate);
FIG. 10B is a side view of the camera module manufacturing workpiece of FIG 10A after enough material has been removed to separate the unitary transparent substrate into a plurality of individual protective covers;
FIG. 11 is a side view of the camera module manufacturing workpiece of FIG. 10B (inverted) with a plurality of image capture devices installed thereon;
FIG. 12 is a side view of the camera module manufacturing workpiece of FIG. 11 with a plurality of individual lens holders installed thereon;
FIG. 13 is a side view of the camera module manufacturing workpiece of FIG. 12 being separated into individual camera modules;
FIG. 14 is a side view of an individual camera module of FIG. 13;
FIG. 15 is a flowchart summarizing one particular method for manufacturing camera modules including image capture devices with protective covers mounted thereon;
FIG. 16 is a flowchart summarizing one particular method for forming a unitary transparent substrate;
FIG. 17 is a flowchart summarizing one particular method for bonding a unitary transparent substrate to a unitary component substrate; and
FIG. 18 is a flowchart summarizing a method for creating camera modules including printed circuit board substrates and protective covers.

### DETAILED DESCRIPTION

Particular embodiments of the present invention will now be described with reference to the drawings. In the following description, numerous specific details are set forth (e.g., certain manufacturing and assembly processes, example lens housings, etc.) in order to provide a thorough understanding of the invention. Those skilled in the art will recognize, however, that the invention may be practiced apart from these specific details. In other instances, details of well known manufacturing practices (e.g., semiconductor fabrication, optical bonding, component mounting, etc.) and components have been omitted, so as not to unnecessarily obscure the present invention. It should be understood that the full scope of the invention is not limited by this detailed description of particular embodiments of the invention.

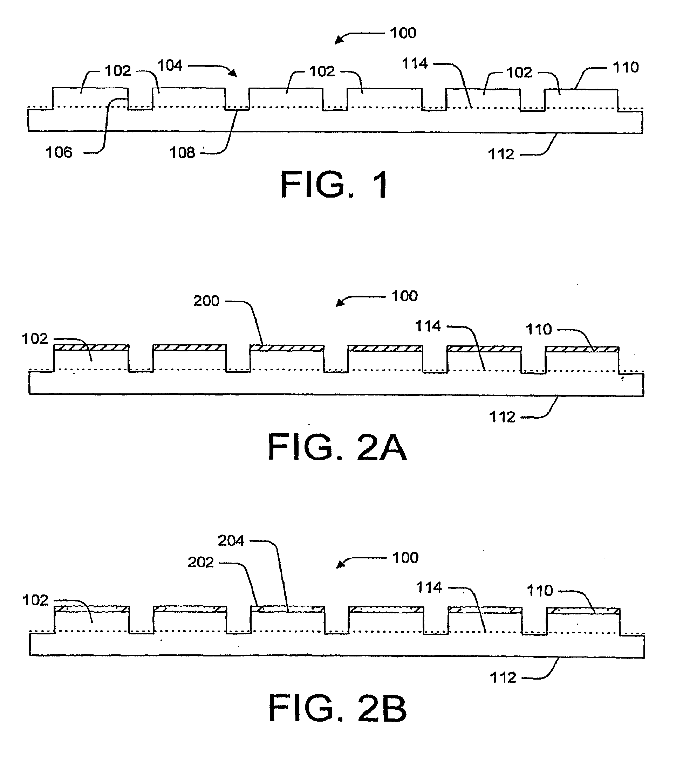

FIG. 1 is a cross-sectional view of a unitary transparent substrate 100 that includes a plurality of individual protective covers 102 partially defined by a plurality of channels 104. The channels 104 are formed in a top surface 110 of substrate 100 and have a depth 106 and a width 108. The width 108 of channels 104 defmes the desired size of and spacing between adjacent covers 102. The depth 106 of channels 104 is equal to, or slightly greater than the desired final thickness of the covers 102. Dotted line 114 indicates a desired thickness of protective covers 102 for this particular example. The bottom surface 112 of unitary transparent substrate 100 is flat and continuous and holds protective covers 102 together during the assembly process, as will be described below.

In this example embodiment, unitary transparent substrate is formed of glass. However, it should be understood that any optically suitable transparent material could be used instead including, but not limited to, clear plastic. In addition, the material itself may provide an optical function (e.g., a filter) by design.

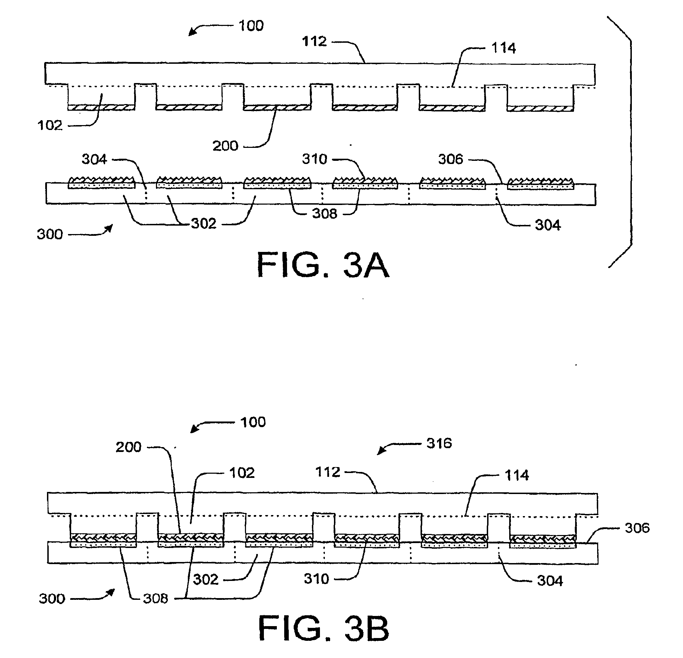

FIG. 2A is a cross-sectional view of the unitary transparent substrate 100 of FIG. 1 with a bonding agent 200 applied to the top surfaces 110 of the individual protective covers 102. In the embodiment of FIG. 2, bonding agent 200 is an optical quality bonding agent, because bonding agent 200 covers the entire top surface 110 of each of protective covers 102. Bonding agent 200 can be applied by a dropper, by a spin-on process, as a laminate, or by any other suitable means. One particular bonding agent found to be suitable is thermosetting optical adhesive that is applied as either a spin-on coating or laminate. The adhesive is partially cured after being applied to protective covers 102. The partially cured adhesive is then fully cured by the application of heat and pressure between the bonded components, as will be described below with reference to FIG. 3B.

FIG. 2B is a cross-sectional view of unitary transparent substrate 100 with an alternate bonding agent 202 applied on the top surfaces 110 of the individual protective covers 102. Alternate bonding agent 202 is patterned so as not to cover a central portion 204 of each cover 102. Instead, the bonding agent forms a closed ring around the peripheral portions of each individual cover 102, while the central portions 204 remain free of adhesive.

The patterning of bonding agent 202 provides at least one advantage. In particular, bonding agent 202 need not be an optical bonding agent, because the bonding agent 202 is not disposed in the optical paths through the centers 204 of protective covers 102. Therefore, the bonding agent can be selected solely based on its suitability (e.g., strength, durability, ease of application, cost, and so on) to hold protective covers 102 in place, without concern for the optical properties of bonding agent 202.

Patterned bonding agent 202 can be conveniently applied as a laminate material. For example, a single sheet of double-sided adhesive material can be applied over the entire top surface 110 of unitary transparent substrate 100. Then the desired pattern is cut into the sheet and the excess material is removed, leaving behind patterned bonding agent 202. Optionally, the sheet can be cut and the excess material removed prior to applying the laminate to the protective covers 102.

FIG. 3A is a cross-sectional view of unitary transparent substrate 100 inverted and disposed over a unitary component substrate 300. Component substrate 300 includes a plurality of individual component parts (integrated image capture devices) 302. Boundaries between the individual devices 302 are indicated by vertical dotted lines 304. As those skilled in the art of semiconductor fabrication will understand, image capture devices 302 are formed in the top surface 306 of component substrate 300. Each of devices 302 include a photosensitive sensor array 308 and an array of micro-lenses 310 overlying each sensor array 308.

The layout of sensor arrays 308 in component substrate 300 corresponds to the layout of protective covers 102 in unitary transparent substrate 100. Thus, when transparent substrate 100 is properly positioned over component substrate 300, each individual protective cover 102 will be properly positioned over an associated one of sensor arrays 308. This alignment facilitates the placement of several covers 102 onto several respective image capture devices 302 at one time. In this particular embodiment, transparent substrate 100 and component substrate 300 include 36 (6x6 array) individual protective covers 102 and devices 302, respectively, even though only one dimension of the array is shown.

FIG 3B is a cross-sectional view of unitary transparent substrate 100 and component substrate 300 bonded together to form an intermediate camera module manufacturing workpiece 316. Bonding agent 200 is held in direct contact with micro-lenses 310 and is cured by the application of heat and pressure. The cured bonding agent forms a hermetic seal between protective covers 102 and micro-lenses 310, thereby protecting image capture devices 302 against contamination that might otherwise occur in later assembly steps.

Note that transparent substrate 100 has bonding agent 200 applied, as shown in the embodiment of FIG. 2A. Therefore, the dimensions of covers 102 are roughly the same as the dimensions of sensor arrays 308. If patterned bonding agent 202 shown in FIG. 2B were used instead, then protective covers 102 would need to be slightly larger than sensor arrays 308 , so that patterned bonding agent 202 would contact top surface 306 of component substrate 300 around, but not on top of, each sensor array 308. In addition, covers 102 and bonding agent 200 should not obstruct or contaminate bonding pads (not shown) located on top surface 306 of component substrate 300.

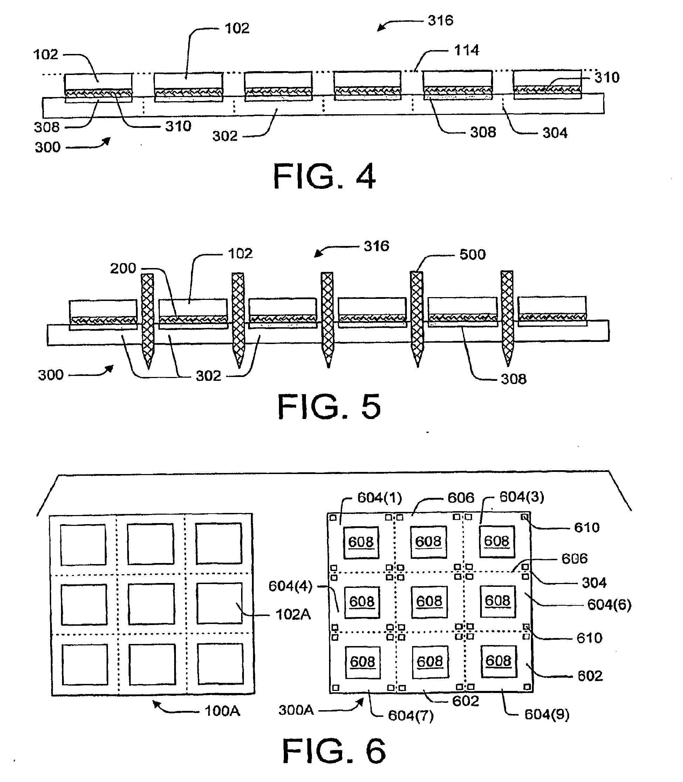

FIG. 4 is a cross-sectional view of intermediate manufacturing workpiece 316 after material has been removed from bottom surface 112 (FIG. 2A) of transparent substrate 100. Removal of material from bottom surface 112 down to line 114 divides unitary transparent substrate 100 into individual protective covers 102.

The material removal process can be accomplished in a number of ways including, but not limited to, etching, scratching, milling, lapping, and so on. These processes are all similar in that they remove material from bottom surface 112 (FIG. 3B) of the unitary transparent substrate 100 to at least the channel depth 106 (FIG. 3B), thus leaving only the individual protective covers 102 in place over respective micro-lenses 310. This method allows the individual protective covers 102 to be much thinner than in the methods of the prior art. Additionally, because individual protective covers 102 were bonded over imager micro-lenses 310 prior to the separation process, contaminants from the separation process of unitary transparent substrate 100 can not cause contamination of lens arrays 308 or micro-lenses 310.

FIG. 5 shows a cross-sectional view of camera module manufacturing workpiece 316 being cleaved along lines 304 (FIG. 4) to divide unitary component substrate 300 into a plurality of individual image capture integrated circuit chips 302, each having a protective cover 102 mounted thereon. In the example method of FIG. 5, a plurality of dicing blades 500 are used to saw through component substrate 300. Other singulation methods are known in the art and are suitable for use with the present invention. However, the particular type of singulation process used is not particularly relevant to the present invention. What is relevant is that protective covers 102 protect sensor arrays 308 from contamination during the singulation process.

FIG. 6 is a top plan view of an alternate unitary transparent substrate 100A and an alternate unitary component substrate 300A. Alternate unitary transparent substrate 100A is similar to unitary transparent substrate 100 however the dimensions of individual protective covers 102A are modified to be complementary to alternate unitary component substrate 300A, as will be described below. In addition, in this example embodiment, unitary transparent substrate 100A includes only nine devices (3x3 array), whereas transparent substrate 100 includes 36 devices (6x6 array). It should be understood, however, that the invention can be practiced with substrates embodying different numbers of individual components, which may or may not be arranged in a square or rectangular array. For example, if component substrate 300 (FIG. 3A) is a silicon wafer of integrated image capture devices, then component substrate 300 would likely include several hundred individual image capture devices.

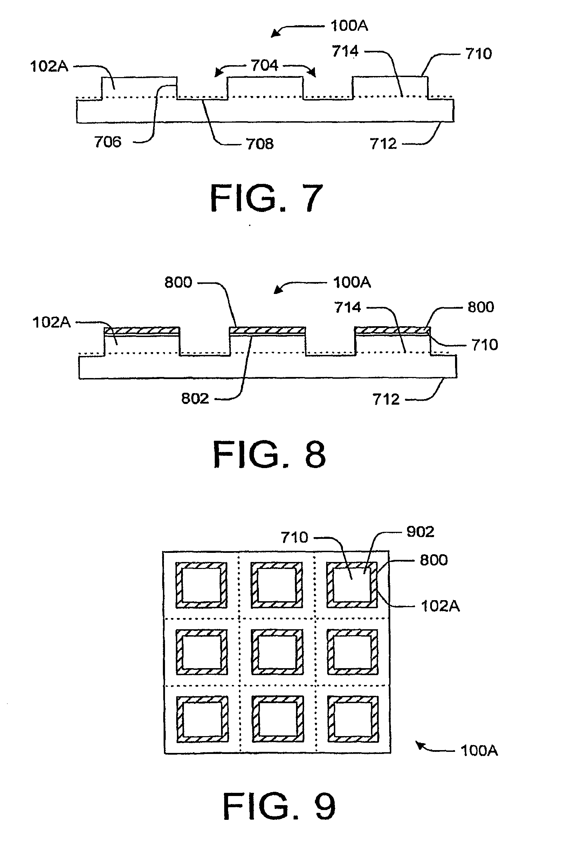

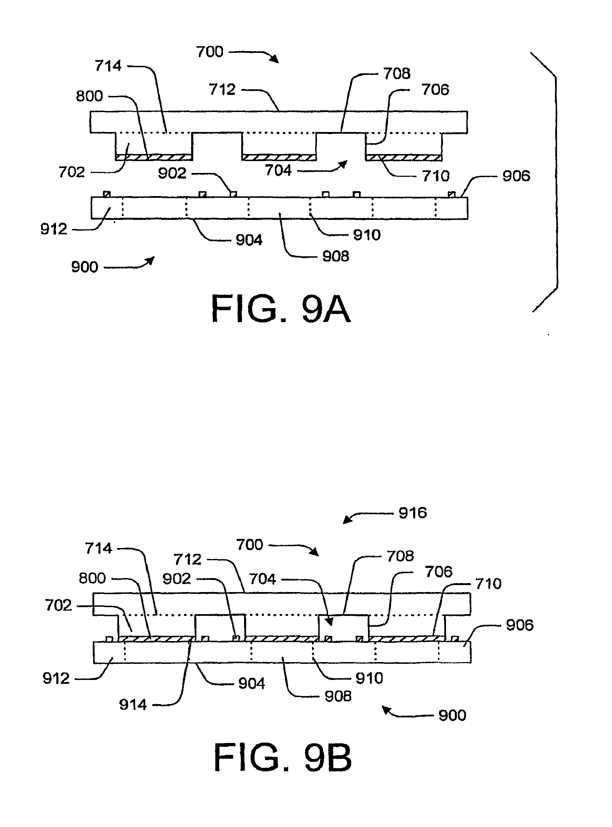

Alternate unitary component substrate 300A is formed from a single piece of circuit board material 602 and includes nine individual device boards 604(1-9) (not all labeled). Dotted lines 606 show the boundaries of individual device boards 604(1-9). Each individual device board 604 defines a central opening 608 and includes a plurality of passive electronic components 610. Each device board 604 also includes electronic circuit traces and contact pads, which are not shown so as not to unnecessarily obscure the drawings. Together, the circuit traces, passive components 610, and an image capture device (FIG. 9) form the electronic circuitry of a camera module, as will be described below.

FIG. 7 is a side view of alternate transparent substrate 100A showing individual protective covers 102A separated by a plurality of channels 704. As in the previous embodiment, the depth 706 and the width 708 of channels 704 define the spacing and approximate thickness of individual protective covers 102A. Dotted line 714 indicates the desired final thickness for the individual protective covers 102A. For reference in subsequent drawings, the top surface of transparent substrate 102A is labeled as 710 and the bottom surface is labeled as 712.

FIG. 8 is a side view of alternate unitary transparent substrate 100A with a bonding agent 800 applied to the top surfaces 710 of the individual protective covers 102A. In this embodiment, bonding agent 800 is applied as a laminate, but any other suitable method can be employed.

Also, an optional optical coating 802 (e.g., an infrared filter, thin film layers, etc.) is formed on top surface 710 prior to applying bonding agent 800. Forming such optical coatings on protective covers 102A eliminates the need for a separate element in the camera module.

FIG. 9 is a top plan view of alternate transparent substrate 100A with bonding agent 800 applied to individual protective covers 102A. Bonding agent 800 is patterned around the peripheral edges of the top surfaces 710 of the individual protective covers 102A. Center portions 902 of protective covers 102A are free of bonding agent 800, so as to provide a clear optical path. Alternatively, the entire top surfaces 710 of protective covers 102A can be covered with an optical bonding agent.

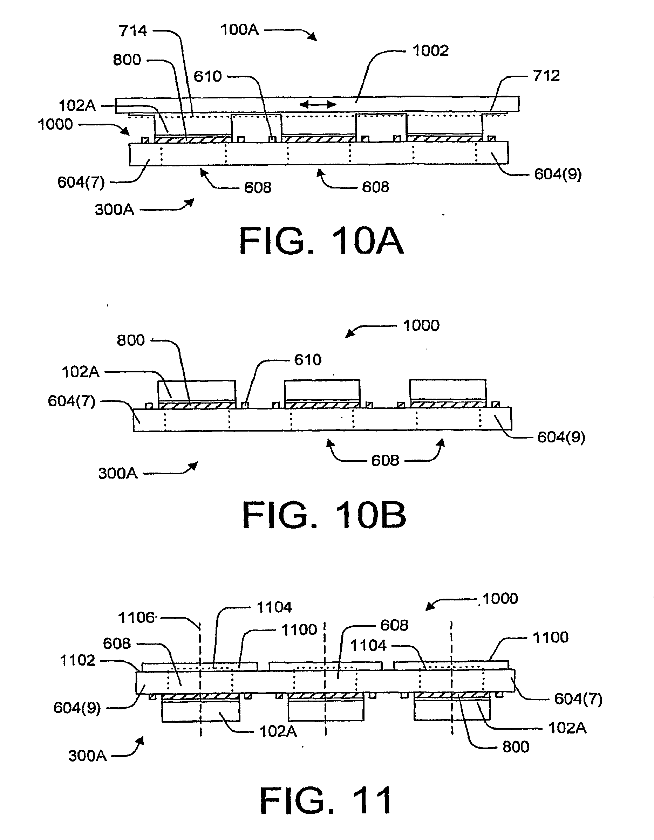

FIG. 10A is a side view of alternate unitary transparent substrate 100A inverted and bonded to component substrate 300A to form an intermediate manufacturing workpiece 1000. Transparent substrate 100A is aligned with component substrate 300A such that patterned bonding agent 800 contacts device boards 604 around the openings 608. Note also that passive devices 610 are sufficiently spaced from openings 608 to provide sufficient contact area for bonding agent 800.

FIG. 10A also shows a lapping mechanism 1002 removing material from the bottom surface 712 of transparent substrate 100A. Lapping mechanism 1002 (e.g., a grinder, an abrasive block, an etchant bath, etc.) is shown representationally, because the details of the actual machine are not particularly relevant to the present invention. In the view of FIG. 10A, the removal of material is nearly complete, but the lapping process will continue until lapping mechanism 1002 reaches dotted line 714.

FIG. 10B is a side view of intermediate manufacturing workpiece 1000 after the lapping process is complete. At this stage, protective covers 102A are completely separated from one another and are each bonded to a respective one of device boards 604(1-9).

The separation process also allows individual protective covers 102A to be much thinner than protective covers of the prior art. In particular, the lapping process can be carried out until protective coves 102A are too thin to be handled by conventional pick-and-place assembly machines. For example, protective covers 102 (FIG. 5) and 102A can be less than 0.5 mm thick.

Note that the components of the invention are not drawn to scale in the drawings. For example, the thickness of protective covers 102A is exaggerated compared to the other components. Although protective covers 102A appear to be about the same thickness as component substrate 300A, they are actually much thinner.

FIG. 11 is a side view of the camera module manufacturing workpiece 1000 being inverted and having a plurality of image capture devices 1100 mounted on the bottom surface 1102 of component substrate 300A. Image capture devices 1100 are attached to bottom surface 1102 of component substrate 300A by automated electronic manufacturing equipment. Circuitry (not shown) of imagers 1100 is connected to circuitry (not shown) of device boards 604 during the mounting process by a gold stud flip-chip bonding process using nonconductive paste.

Image capture devices 1100 are positioned on bottom surface 1102 of component substrate 300A so that sensor arrays 1104 of image capture devices 1100 align with openings 608 through component substrate 300A. In particular, each image capture device 1100 is positioned so that its sensor array 1104 is centered on a respective optical axis 1106 passing through a corresponding opening 608. As will be described below, other optical components of the camera modules will be aligned with respect to optical axes 1106.

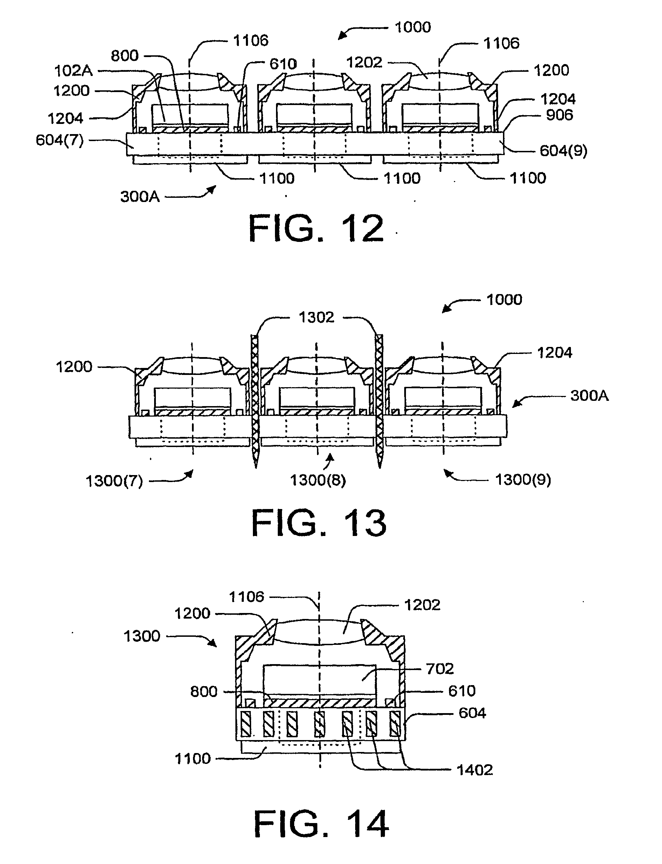

FIG. 12 is a side view of camera module manufacturing workpiece 1000 with a plurality of lens holders 1200 mounted thereon. Lens holders 1200 are shown in partial cross-section to each include a lens element 1202 supported by a housing 1204. Lens holders 1200 are positioned so that lens elements 1202 are each centered on one of optical axes 1106. In addition, housings 1204 each surround passive components 610 and the protective cover 102A of a respective device board 604. Lens holder 1200 is attached with an adhesive (not show).

Lens holders 1200 are intended to be simplified representations of lens holders. The specific details of the actual lenses and housings (e.g., number of lenses, lens material, focus mechanisms, etc.) are not considered to be especially relevant to the practice of the invention. What is relevant, however, is that the camera module optics can be mounted, aligned, focused, and/or tested while device boards 604 are still an integral part of component substrate 300A.

FIG. 13 is a side view (lens holders 1200 shown in partial cross-section) of the camera module manufacturing workpiece 1000 undergoing a process to separate unitary component substrate 300A into individual camera modules 1300. In the example process shown in FIG. 13, a plurality of dicing blades 1302 are spaced to saw through component substrate 300A between the individual camera modules 1300, first along the direction shown and then along a perpendicular direction. Various other methods for dividing unitary component substrate 300A can be used with the present invention including, but not limited to, routing, punching, and so on.

FIG. 14 is a side view of an individual camera module 1300 showing a plurality of electrical contact pads 1402 (7 shown, 3 labeled) on an edge of device board 604. Contact pads 1402 are connected to the internal circuitry of camera module 1300 and are used to electronically connect camera module 1300 to a host device (e.g., digital camera, cell phone, etc.). Although contact pads 1402 are shown on the edge of device board 604 by way of example, it should be understood that contact pads 1402 can optionally be formed on the top or bottom surface of device board 604, either before or after the division of unitary component substrate 300A.

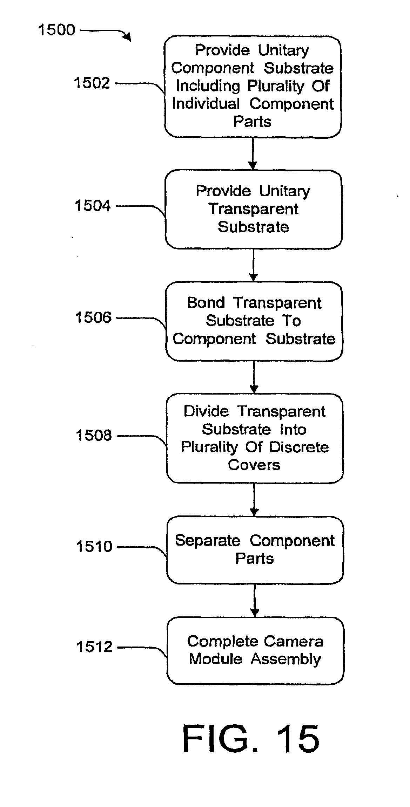

FIG. 15 is a flowchart summarizing a method 1500 for manufacturing camera modules including image capture devices with protective covers mounted thereon. In a first step 1502 a unitary component substrate including a plurality of individual component parts is provided. Next, in a second step 1504, a unitary transparent substrate is provided. Then, in a third step 1506, the unitary transparent substrate is bonded to the unitary component substrate. Next, in a fourth step 1508, the unitary transparent substrate is divided into a plurality of discrete protective covers. Then, in a fifth step 1510, the unitary component substrate is separated into component parts. Finally, in a sixth step 1512, the camera module assembly is completed.

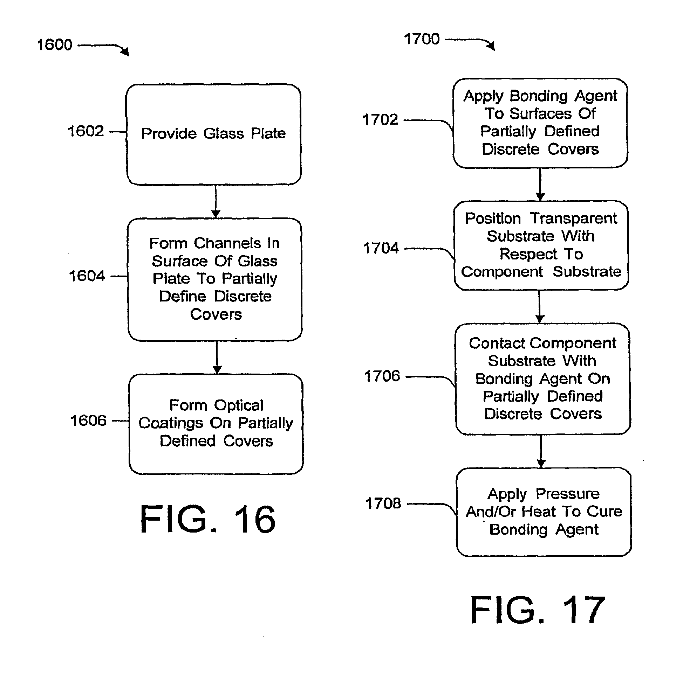

FIG. 16 is a flowchart summarizing a method 1600 for performing second step 1504 (providing a unitary transparent substrate) of method 1500. In a first step 1602, a glass plate is provided. Next, in a second step 1604, channels are formed in the surface of the glass plate to partially define discrete protective covers. Finally, in a third step 1606, optical coatings are formed on the surfaces of the partially defined protective covers.

FIG. 17 is a flowchart summarizing a method 1700 for performing third step 1506 (bonding unitary transparent substrate to unitary component substrate) of method 1500. In a first step 1702, a bonding agent is applied to the surfaces of the partially defined protective covers. Next, in a second step 1704, the transparent substrate is positioned with respect to the component substrate. Then, in a third step 1706, the component substrate is brought in contact with the bonding agent on the partially defined protective covers. Next, in a final step 1708, the bonding agent is cured.

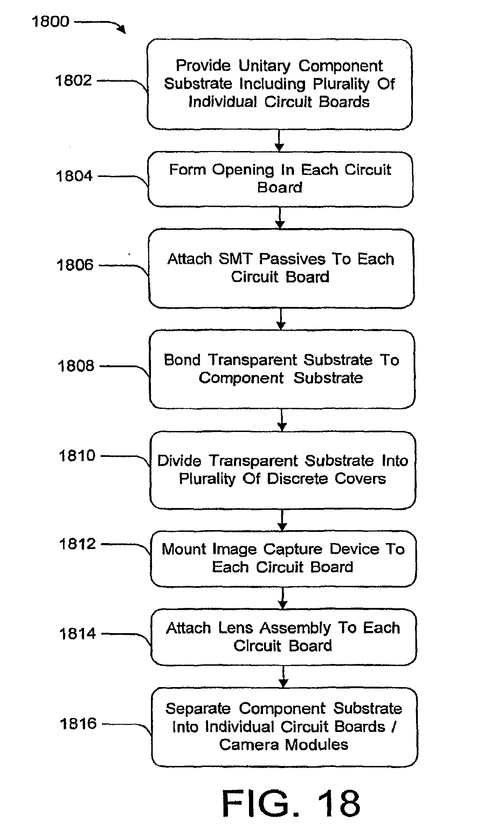

FIG. 18 is a flowchart summarizing a method 1800 for creating a camera module with a printed circuit board substrate. In a first step 1802, a unitary component substrate including a plurality of individual circuit boards is provided. Next, in a second step 1804, openings are formed in each circuit board. Then, in a third step 1806, passive electronic components are attached to each circuit board. Next, in a fourth step 1808, a transparent substrate is bonded to the component substrate. Then, in a fifth step 1810, the transparent substrate is divided into a plurality of discrete protective covers. Next, in a sixth step 1812, image capture devices are attached to each circuit board. Then, in a seventh step 1814, lens assemblies are attached to each circuit board. Finally, in an eighth step 1816, the component substrate is separated into the individual circuit boards to form individual camera modules.

The description of particular embodiments of the present invention is now complete. Many of the described features may be substituted, altered or omitted without departing from the scope of the invention. For example, the invention can be practiced with other types of unitary component substrates and/or unitary transparent substrates. As another example, the layout and structure of the individual covers within the unitary transparent substrate and the devices within the unitary component substrate can be modified. As yet another example, in the embodiment of FIGs. 6-14, image capture devices 1100 can be mounted to component substrate 300A prior to dividing transparent substrate 100A into individual protective covers 102A. These and other deviations from the particular embodiments shown will be apparent to those skilled in the art, particularly in view of the foregoing disclosure.

## Claims

1. Method for manufacturing camera modules (1300), said method comprising:
providing an integrated circuit wafer (300) including a of integrated image capture devices (302), a top surface (306), and a bottom surface (1102), each of said integrated image capture devices including a sensor array (308) formed in said top surface (306) and including an array of micro-lenses (310) disposed over said sensor array (308);
providing a unitary transparent substrate (100) including first surface (110) and a second surface (112);
forming a plurality of channels (104), each channel having a depth and a width in said first surface (110) of said transparent substrate (100) to least partially define protective covers (102) having dimensions substantially the same as the dimensions of said sensor array (308), wherein the width (108) of the channels (104) define a size of and spacing between adjacent protective covers (102), and wherein said channels are at least as deep as a predetermined thickness of said protective covers (102);
bonding said first surface (110) of said transparent substrate (100) to said array of micro-lenses (310);
dividing said transparent substrate (100) into a plurality of discrete protective covers (102) after said transparent substrate (100) is bonded to said array of micro-lenses (310), each of said protective covers (102) being bonded directly to micro-lenses (310) and disposed over said sensor array (308) of said respective one of said image capture devices (302), wherein dividing said transparent substrate (100) into a plurality of discrete protective covers (102) comprises removing material, including material directly opposite said sensor array (308), from said second surface (112) of said transparent substrate (100) until said channels (104) pass completely through said transparent substrate (100);
and
separating said image capture devices (302) from one another in a step separate from said step of dividing said transparent substrate (100).

2. Method for manufacturing camera modules according to claim 1, wherein said step of bonding said first surface (110) of said transparent substrate (100) to said array of micro-lenses (310) includes applying a bonding agent (200) to said first surface (110) of said transparent substrate (100) defining said protective covers (102).

3. Method for manufacturing camera modules according to claim 1, wherein:
said channels (104) include a first group of channels paralel to one another;
said channels (104) include a second group of channels parallel to one another and perpendicular to said channels of said first group of channels; and
said protective covers (102) are rectangular in shape and disposed between adjacent pairs of said channels.

4. Method for manufacturing camera modules according to claim 3, wherein said step of applying a bonding agent (200) to said first surface (110) of said transparent substrate (100) defining said protective covers (102) includes applying an optical bonding agent (200) to substantially the entire area of said first surface (110) of said transparent substrate (100) defining said protective covers (102).

5. Method for manufacturing camera modules according claim 3, wherein said step of applying a bonding agent (200) to said first surface (10) of said transparent substrate (100) defining said protective covers (102) includes patterning said bonding agent (200) on said first surface (110) of said transparent substrate (100) such that said bonding agent (200) forms a closed perimeter around a periphera portion of each of said protective covers (102) and leaves a central portion free of said bonding agent (200).

6. Method for manufacturing camera modules according to claim 3, wherein said step of applying a bonding agent (200) to said first surface (110) of said transparent substrate (100) defining said protective covers (102) includes laminating said bonding agent (200) on said first surface (110) of said transparent substrat (100).

7. Method for manufacturing camera modules according claim 3, wherein said step of bonding said first surface (110) of said transparent substrate (100) to said array of micro-lenses (310) includes:
positioning said transparent substrate (100) such that said bonding agent (200) directly contacts micro-lenses (310) ; and
completing the curing process of said bonding agent (200).

8. Method for manufacturing camera modules according to claim 1, wherein said step of bonding said first surface (110) of said transparent substrate (100) to said array of micro-lenses (310) includes:
applying a bonding agent (200) to one of said first surface (110) of said transparent substrate (100) and said array of micro-lenses (310) ; and
positioning said transparent substrate (100) such that said bonding agent (200) contacts said first surface (110) of said transparent substrate (100) and micro-lenses (310).

9. Method for manufacturing camera modules according to claim 1, wherein said step of bonding said first surface (110) of said transparent substrate (100) to said array of micro-lenses (310) includes using a partially cured thermosetting adhesive.

10. Method for manufacturing camera modules according to claim 1, wherein said step of separating said image capture devices (302) occurs after said step of dividing said transparent substrate (100).

11. Method for manufacturing camera modules according to claim 1, further comprising mounting a lens holder (1200) on said integrated circuit wafer (300) after said step of dividing said transparent substrate (100) but before said step of separating said image capture devices (302).

12. Method for manufacturing camera modules according to claim 1, further comprising forming an optical filter (802) on said protective covers (102).

13. Camera module manufacturing workpiece comprising:
an integrated circuit wafer (300) including a plurality of individual image capture devices (302), each of said image capture devices (302) including a top surface (306) having a sensor array (308) formed therein and further including an array of micro-lenses (310) disposed over said sensor array (308); and
a unitary transparent substrate (100) including a first surface (110), said first surface (110) partially defining a plurality of discrete protective covers (102) having dimensions substantially the same as the dimensions of said sensor array (308) and each being bonded directly to micro-lenses (310) and disposed over said sensor array (308) of said respective one of said image capture devices (302),
wherein said discrete protective covers (102) are at least partially defined by channels (104) formed in said first surface (110) of said unitary transparent substrate (100), wherein the width (108) of the channels (104) define a size of and spacing between adjacent protective covers (102), and wherein said channels are at least as deep as a predetermined thickness of said protective covers (102).

14. Camera module manufacturing workpiece according to claim 13, wherein the depth of each of said channels is no greater than 300 microns.

## Patentansprüche

1. Verfahren zum Herstellen von Kameramodulen (1300), das Verfahren mit den Schritten:
Bereitstellen eines Integrierte-Schaltung-Wafers (300) mit einer Mehrzahl von integrierten bildaufnehmenden Bauteilen (302), einer oberen Oberfläche (306) und einer unteren Oberfläche (1102), wobei jedes integrierte bildaufnehmende Bauteil ein Sensorarray (308) aufweist, das in der oberen Oberfläche (306) ausgebildet ist und ein Array von Mikro-Linsen (310) aufweist, das über dem Sensorarray (308) angeordnet ist;
Bereitstellen eines einheitlichen transparenten Substrats (100) mit einer ersten Oberfläche (110) und einer zweiten Oberfläche (112);
Ausbilden von einer Mehrzahl von Kanälen (104), wobei jeder Kanal eine Tiefe und eine Breite in der ersten Oberfläche (110) des transparenten Substrats (100) hat, um zumindest teilweise schützende Abdeckungen (102) zu definieren, die Abmessungen haben, die im Wesentlichen dieselben sind wie die Abmessungen des Sensorarrays (308), wobei die Breite (108) der Kanäle (104) eine Größe und einen Abstand zwischen angrenzenden schützenden Abdeckungen (102) definieren und wobei die Kanäle zumindest so tief sind wie eine vorgegebene Dicke der schützenden Abdeckungen (102);
Bonden der ersten Oberfläche (110) des transparenten Substrats (100) an das Array der Mikro-Linsen (310);
Teilen des transparenten Substrats (100) in eine Mehrzahl von diskreten schützenden Abdeckungen (102) nachdem das transparente Substrat (100) an das Array von Mikro-Linsen (310) gebondet wurde, wobei jede der schützenden Abdeckungen (102) direkt an die Mikro-Linsen (310) gebondet ist und über dem Sensorarray (308) des entsprechenden bildaufnehmenden Bauteils (302) angeordnet ist, wobei das Teilen des transparenten Substrats (100) in eine Mehrzahl von diskreten schützenden Abdeckungen (102) ein Entfernen von Material, einschließlich von Material direkt gegenüber vom Sensorarray (308), von der zweiten Oberfläche (112) des transparenten Substrats (100) aufweist, bis die Kanäle (104) vollständig durch das transparente Substrat (100) hindurchgehen;
und
Trennen der bildaufnehmenden Bauteile (302) voneinander in einem Schritt, der separat ist von dem Schritt des Teilens des transparenten Substrats (100).

2. Verfahren zum Herstellen von Kameramodulen nach Anspruch 1, wobei der Schritt des Bondens der ersten Oberfläche (110) des transparenten Substrats (100) an das Array von Mikro-Linsen (310) das Aufbringen eines Bond-Mittels (200) auf der ersten Oberfläche (110) des transparenten Substrats (100) aufweist, das die schützenden Abdeckungen (102) definiert.

3. Verfahren zum Herstellen von Kameramodulen nach Anspruch 1, wobei:
die Kanäle (104) eine erste Gruppe von Kanälen aufweisen, die parallel zueinander sind;
die Kanäle (104) eine zweite Gruppe von Kanälen aufweisen, die parallel zueinander sind und senkrecht zu den Kanälen der ersten Gruppe von Kanälen sind; und
die schützenden Abdeckungen (102) eine rechteckige Form aufweisen und zwischen benachbarten Paaren der Kanäle angeordnet sind.

4. Verfahren zum Herstellen von Kameramodulen nach Anspruch 3, wobei der Schritt des Aufbringens eines Bond-Mittels (200) auf die erste Oberfläche (110) des transparenten Substrats (100), das die schützenden Abdeckungen (102) definiert, das Aufbringen eines optischen Bond-Mittels (200) aufweist, und zwar im Wesentlichen auf die gesamte Fläche der ersten Oberfläche (110) des transparenten Substrats (100), das die schützenden Abdeckungen (102) definiert.

5. Verfahren zum Herstellen von Kameramodulen nach Anspruch 3, wobei der Schritt des Aufbringens eines Bond-Mittels (200) auf die erste Oberfläche (110) des transparenten Substrats (100), das die schützenden Abdeckungen (102) definiert, das Formen des Bond-Mittels (200) auf der ersten Oberfläche (110) des transparenten Substrats (100) aufweist, so dass das Bond-Mittel (200) eine geschlossene Umgrenzung um einen äußeren Abschnitt von jedem der schützenden Abdeckungen (102) bildet und einen zentralen Abschnitt von dem Bond-Mittel (200) freilässt.

6. Verfahren zum Herstellen von Kameramodulen nach Anspruch 3, wobei der Schritt des Aufbringens eines Bond-Mittels (200) auf die erste Oberfläche (110) des transparenten Substrats (100), das die schützenden Abdeckungen (102) definiert, ein Laminieren des Bond-Mittels (200) auf die erste Oberfläche (110) des transparenten Substrats (100) aufweist.

7. Verfahren zum Herstellen von Kameramodulen nach Anspruch 3, wobei der Schritt des Bondens der ersten Oberfläche (110) des transparenten Substrats (100) an das Array von Mikro-Linsen (310) aufweist:
Positionieren des transparenten Substrats (100), so dass das Bond-Mittel (200) die Mikro-Linsen (310) direkt kontaktiert; und
Abschließen des Härtungsprozesses des Bond-Mittels (200).

8. Verfahren zum Herstellen von Kameramodulen nach Anspruch 1, wobei der Schritt des Bondens der ersten Oberfläche (110) des transparenten Substrats (100) an das Array von Mikro-Linsen (310) aufweist:
Aufbringen eines Bond-Mittels (200) auf entweder die erste Oberfläche (110) des transparenten Substrats (100) oder das Array von Mikro-Linsen (310); und
Positionieren des transparenten Substrats (100), so dass das Bond-Mittel (200) die erste Oberfläche (110) des transparenten Substrats (100) und die Mikro-Linsen (310) kontaktiert.

9. Verfahren zum Herstellen von Kameramodulen nach Anspruch 1, wobei der Schritt des Bondens der ersten Oberfläche (110) des transparenten Substrats (100) an das Array von Mikro-Linsen (310) die Verwendung eines teilweise gehärteten Adhäsivs aufweist, das auf Temperatur reagiert.

10. Verfahren zum Herstellen von Kameramodulen nach Anspruch 1, wobei der Schritt des Trennens der bildaufnehmenden Bauteile (302) nach dem der Schritt des Teilens des transparenten Substrats (100) stattfindet.

11. Verfahren zum Herstellen von Kameramodulen nach Anspruch 1, ferner mit dem Schritt des Befestigens eines Linsenhalters (1200) auf dem Integrierte-Schaltung-Wafer (300) nach dem Schritt des Teilens des transparenten Substrats (100), aber vor dem Schritt des Trennens der bildaufnehmenden Bauteile (302).

12. Verfahren zum Herstellen von Kameramodulen nach Anspruch 1, ferner mit dem Schritt eines Ausbildens eines optischen Filters (802) auf den schützenden Abdeckungen (102).

13. Werkstück zum Herstellen eines Kameramoduls mit:
einem Integrierte-Schaltung-Wafer (300) mit einer Mehrzahl von einzelnen bildaufnehmenden Bauteilen (302), wobei jedes bildaufnehmende Bauteil (302) eine obere Oberfläche (306), die ein Sensorarray (308) hat, das darin ausgebildet ist, und ferner mit einem Array von Mikro-Linsen (310), die über dem Sensorarray (308) angeordnet sind; und
einem einheitlichen transparenten Substrat (100) mit einer ersten Oberfläche (110), wobei die erste Oberfläche (110) teilweise eine Mehrzahl von diskreten schützenden Abdeckungen (102) definiert, die Abmessungen haben, die im Wesentlichen den Abmessungen des Sensorarrays (308) entsprechen und jede direkt auf die Mikro-Linsen (310) gebondet ist und über dem Sensorarray (308) eines entsprechenden Bauteils der bildaufnehmenden Bauteile (302) angeordnet ist,
wobei die diskreten schützenden Abdeckungen (102) zumindest teilweise durch Kanäle (104) definiert sind, die in der ersten Oberfläche (110) des einheitlichen transparenten Substrats (100) ausgebildet sind, wobei die Breite (108) der Kanäle (104) eine Größe und Abstand zwischen benachbarten schützenden Abdeckungen (102) definiert und wobei die Kanäle zumindest so tief sind wie eine vorgegebene Dicke der schützenden Abdeckungen (102).

14. Werkstück zum Herstellen eines Kameramoduls nach Anspruch 13, wobei die Tiefe von jedem der Kanäle nicht größer ist als 300 µm.

## Revendications

1. Procédé de fabrication de modules de caméra (1300), lequel procédé consiste à :
utiliser une plaquette de circuit intégré (300) comprenant plusieurs dispositifs de capture d'image intégrés (302), une surface supérieure (306) et une surface inférieure (1102), chacun desdits dispositifs de capture d'image intégrés comprenant un réseau de capteurs (308) formé dans ladite surface supérieure (306), et comprenant un réseau de microlentilles (310) disposé sur ledit réseau de capteurs (308) ;
- utiliser un substrat transparent unitaire (100) comprenant une première surface (110) et une seconde surface (112) ;
- former plusieurs canaux (104), chaque canal ayant une profondeur et une largeur données dans ladite première surface (110) dudit substrat transparent (100) afin de former en partie au moins des caches de protection (102) ayant des dimensions essentiellement identiques à celles dudit réseau de capteurs (308), la largeur (108) des canaux (104) définissant la taille des caches de protection et l'espacement entre les caches de protection (102) adjacents, et lesdits canaux étant au moins aussi profonds qu'une épaisseur prédé-terminée desdits caches de protection (102) ;
- coller ladite première surface (110) dudit substrat transparent (100) sur ledit réseau de microlentilles (310) ;
- diviser ledit substrat transparent (100) en plusieurs caches de protection (102) discrets une fois que ledit substrat transparent (100) a été collé audit réseau de microlentilles (310), chacun desdits caches de protection (102) étant collé directement aux microlentilles (310) et disposé sur ledit réseau de capteurs (308) d'un dispositif respectif parmi lesdits dispositifs de capture d'image (302), la division dudit substrat transparent (100) en plusieurs caches de protection (102) discrets consistant à retirer de la matière, y compris de la matière directement en face dudit réseau de capteurs (308), de ladite seconde surface (112) dudit substrat transparent (100) jusqu'à ce que lesdits canaux (104) passent complètement à travers ledit substrat transparent (100) ; et
- séparer lesdits dispositifs de capture d'image (302) les uns des autres au cours d'une étape distincte de ladite étape de division dudit substrat transparent (100).

2. Procédé de fabrication de modules de caméra selon la revendication 1, dans lequel ladite étape de collage de ladite première surface (110) dudit substrat transparent (100) sur ledit réseau de microlentilles (310) consiste à appliquer un agent de collage (200) sur ladite première surface (110) dudit substrat transparent (100) définissant lesdits caches de protection (102).

3. Procédé de fabrication de modules de caméra selon la revendication 1, dans lequel :
- lesdits canaux (104) comprennent un premier groupe de canaux parallèles les uns aux autres ;
- lesdits canaux (104) comprennent un second groupe de canaux parallèles les uns aux autres et perpendiculaires auxdits canaux dudit premier groupe de canaux ; et
- lesdits caches de protection (102) sont de forme rectangulaire et sont disposés entre des paires adjacentes desdits canaux.

4. Procédé de fabrication de modules de caméra selon la revendication 3, dans lequel ladite étape d'application d'un agent de collage (200) sur ladite première surface (110) dudit substrat transparent (100) définissant lesdits caches de protection (102), consiste à appliquer un agent de collage optique (200) sur essentiellement toute la superficie de ladite première surface (110) dudit substrat transparent (100) définissant lesdits caches de protection (102).

5. Procédé de fabrication de modules de caméra selon la revendication 3, dans lequel ladite étape d'application d'un agent de collage (200) sur ladite première surface (110) dudit substrat transparent (100) définissant lesdits caches de protection (102), consiste à former des motifs dans ledit agent de collage (200) sur ladite première surface (110) dudit substrat transparent (100) de sorte que ledit agent de collage (200) forme un périmètre clos autour de la partie périphérique de chacun desdits caches de protection (102) et laisse une partie centrale libre de tout agent de collage (200).

6. Procédé de fabrication de modules de caméra selon la revendication 3, dans lequel ladite étape d'application d'un agent de collage (200) sur ladite première surface (110) dudit substrat transparent (100) définissant lesdits caches de protection (102), consiste à stratifier ledit agent de collage (200) sur ladite première surface (110) dudit substrat transparent (100).

7. Procédé de fabrication de modules de caméra selon la revendication 3, dans lequel ladite étape de collage de ladite première surface (110) dudit substrat transparent (100) sur ledit réseau de microlentilles (310) consiste à :
- positionner ledit substrat transparent (100) de sorte que ledit agent de collage (200) entre directement en contact avec les microlentilles (310) ; et
- terminer le processus de solidification dudit agent de collage (200).

8. Procédé de fabrication de modules de caméra selon la revendication 1, dans lequel ladite étape de collage de ladite première surface (110) dudit substrat transparent (100) sur ledit réseau de microlentilles (310) consiste à :
- appliquer un agent de collage (200) sur un de ladite première surface (110) dudit substrat transparent (100) et dudit réseau de microlentilles (310) ; et
- positionner ledit substrat transparent (100) de sorte que ledit agent de collage (200) entre en contact avec ladite première surface (110) dudit substrat transparent (100) et les microlentilles (310).

9. Procédé de fabrication de modules de caméra selon la revendication 1, dans lequel ladite étape de collage de ladite première surface (110) dudit substrat transparent (100) sur ledit réseau de microlentilles (310) consiste à utiliser un adhésif thermodurcissable partiellement solidifié.

10. Procédé de fabrication de modules de caméra selon la revendication 1, dans lequel ladite étape de séparation desdits dispositifs de capture d'image (302) se produit après ladite étape de division dudit substrat transparent (100).

11. Procédé de fabrication de modules de caméra selon la revendication 1, consistant en outre à monter un support de lentilles (1200) sur ladite plaquette de circuit intégré (300) après ladite étape de division dudit substrat transparent (100) mais avant ladite étape de séparation desdits dispositifs de capture d'image (302).

12. Procédé de fabrication de modules de caméra selon la revendication 1, consistant en outre à former un filtre optique (802) sur lesdits caches de protection (102).

13. Pièce à usiner pour la fabrication de modules de caméra, comprenant :
- une plaquette de circuit intégré (300) comprenant plusieurs dispositifs de capture d'image intégrés (302) individuels, chacun desdits dispositifs de capture d'image (302) comprenant une surface supérieure (306) dans laquelle est formé un réseau de capteurs (308) et comprenant en outre un réseau de microlentilles (310) disposé sur ledit réseau de capteurs (308) ; et
- un substrat unitaire transparent (100) comprenant une première surface (110), ladite première surface (110) définissant en partie au moins plusieurs caches de protection discrets (102) ayant des dimensions essentiellement identiques à celles dudit réseau de capteurs (308) et chacun étant collé directement aux microlentilles (310) et disposé sur ledit réseau de capteurs (308) d'un dispositif respectif parmi lesdits dispositifs de capture d'image (302) ;
- dans laquelle lesdits caches de protection discrets (102) sont au moins partiellement définis par des canaux (104) formés dans ladite première surface (110) dudit substrat transparent unitaire (100), la largeur (108) des canaux (104) définissant la taille des caches de protection et l'espacement entre les caches de protection (102) adjacents, et lesdits canaux étant au moins aussi profonds qu'une épaisseur prédéterminée desdits caches de protection (102).

14. Pièce à usiner pour la fabrication de modules de caméra selon la revendication 13, dans laquelle la profondeur de chacun desdits canaux ne dépasse pas 300 microns.
